# EUROPEAN PATENT SPECIFICATION

(11) **EP 1 667 244 B1**
(45) Date of publication and mention of the grant of the patent: **26.01.2011**
(21) Application number: 05257416.7
(22) Date of filing: 01.12.2005
(51) Int. Cl.: H01L 45/00

(54) **Method of fabricating phase change memory device having phase change material layer containing phase change nano particles**
Herstellungsverfahren für Phasenwechselspeichervorrichtung mit Phasenwechselmaterialschicht aus Phasenwechselnanopartikeln
Procédé de fabrication pour dispositif de mémoire à changement de phase comportant une couche de matériau à changement de phase contenant des nanoparticules à changement de phase

(30) Priority: 02.12.2004 KR 20040100358; 15.03.2005 KR 20050021340
(43) Date of publication of application: 07.06.2006
(73) Proprietor: Samsung Electronics Co., Ltd., Suwon-si, Gyeonggi-do (KR)
(72) Inventor: Khang, Yoon-ho, Sanghyeon-dong Yongin-si, Gyeonggi-do (KR); Jo, Wil-liam, Seoul (KR); Suh, Dong-seok, Gangnam-gu Seoul (KR)
(74) Representative: Greene, Simon Kenneth

(56) References cited:
- EP-A- 1 288 930
- US-A1- 2004 052 117
- HORII H ET AL: "A novel cell technology using N-doped GeSbTe films for phase change RAM" SYMPOSIUM ON VLSI TECHNOLOGY, 10-12 JUNE 2003, KYOTO, JAPAN, 2003, pages 177-178, XP001211741 ISBN: 4-89114-033-X

## Description

### BACKGROUND OF THE INVENTION

The present invention relates to a method of fabricating a phase change memory device and more particularly, to a method of fabricating a phase change memory device consuming less electric power and/or having improved current-voltage (I-V) characteristics.

Semiconductor memory devices may be classified as volatile memory devices and non-volatile memory devices according to their capability to retain data when a power supply is disconnected. A dynamic random access memory (DRAM) and a static random access memory (SRAM) are examples of a volatile memory device. Such a memory device stores data as a logic 0 or a logic 1 according to a stored electric potential. DRAM may be able to store many electric charges because a DRAM regularly refreshes. Therefore, research has been conducted to increase the surface area of a capacitor electrode of the DRAM. However, increasing a surface area of a capacitor electrode may make it difficult to integrate a DRAM device.

A flash memory device may include a semiconductor substrate, a gate insulation layer, a floating gate, a dielectric film and/or a gate pattern as a control gate stacked on a semiconductor substrate. A flash memory cell may record or erase data by tunnelling electrons through the gate insulation layer. To tunnel the electrons, an operating voltage greater than a supply voltage may be required. Accordingly, a booster circuit may be required to provide the operating voltage for recording and/or erasing the flash memory device.

Therefore, research has been conducted to develop a new memory device having a simple structure, high integrity and/or non-volatile characteristics and/or providing a random access scheme. Recently, a phase change memory device has been spotlighted as a next generation memory device. A phase change memory device uses a phase change material. The phase change material becomes amorphous or crystalline according to the amplitude of a supplied current, that is, Joule heating, and has distinct electric conductivity according to whether it is in an amorphous state or a crystalline state.

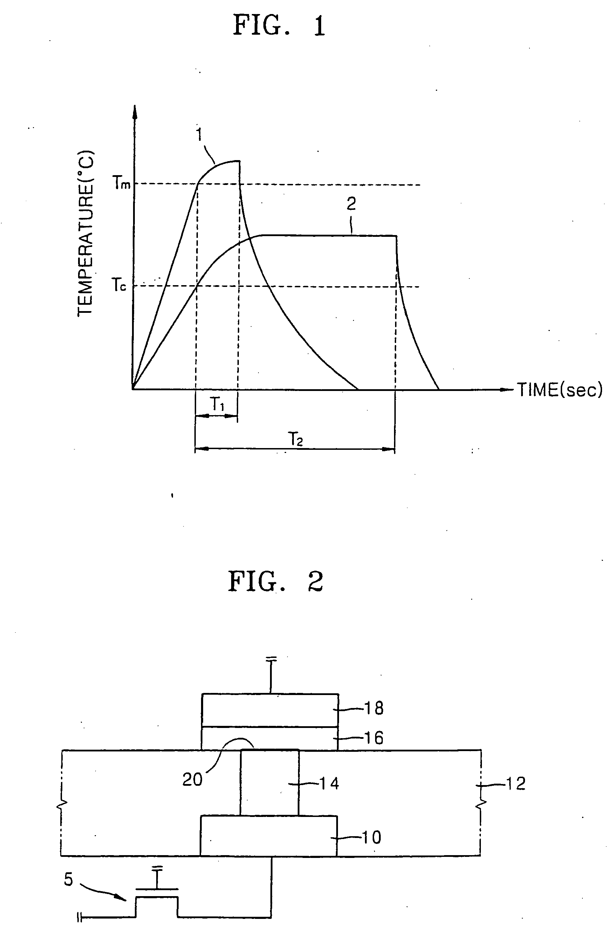

FIG. 1 is a graph illustrating a method of operating a phase change memory device according to the conventional art. A method of recording and erasing data in a phase change memory cell will be explained with reference to the graph in FIG. 1. In the graph, the horizontal axis represents time and the vertical axis represents the temperature of a phase change material layer.

Referring to FIG. 1, if the phase change material layer is heated to a temperature higher than a melting temperature Tm of the phase change material and then suddenly cooled as shown in a first curve 1, the phase material layer enters an amorphous state. On the other hand, if the phase change material layer is heated to a temperature lower than the melting temperature Tm and higher than a crystallization temperature Tc of the phase change material over a time T2, which is longer than T1 as shown in a second curve 2 of the graph, the heated phase change material layer is annealed and enters a crystalline state. The resistivity of the phase change material layer in the amorphous state is greater than the resistivity of the phase change material layer in the crystalline state. Accordingly, stored data can be discriminated as logic 1 or logic 0 by detecting a current flowing through the phase change material layer in a read mode. Chalcogenide materials are widely used as the phase change material. Among the chalcogenide materials, a compound material layer (GST) containing germanium (Ge), antimony (Sb) and tellurium (Te) is widely used in phase change memory.

FIG. 2 is a cross sectional view of a phase change memory device according to the conventional art.

Referring to FIG. 2, the conventional phase change memory device includes a bottom conductive layer 10, a top conductive layer 18, a thin film type of a phase change material layer 16 interposed between the bottom conductive layer 10 and the top conductive layer 18, and/or a contact unit 14 electrically connecting the bottom conductive layer 10 and the phase change material layer 16. The bottom conductive layer 10 and side surfaces of the contact unit 14 may be surrounded by an insulation layer 12. A contacting surface of the contact unit 14 may be electrically coupled to the phase change material layer 16. A transistor 5 may be electrically connected to the bottom conductive layer 10 and a current may be supplied to the bottom conductive layer 10, the top conductive layer 18 and the phase change material layer 16 interposed between the bottom conductive layer 10 and the top conductive layer 18 through the transistor 5. The current supplied to the top conductive layer 18 may flow through the phase change material layer 16, the contact unit 14, the bottom conductive layer 10 and the transistor 5.

In the phase change memory device, if the current flows between the bottom conductive layer 10 and the top conductive layer 18, the current flows to the phase change material layer 16 through the contact unit 14 and the contacting surface 20. According to the Joule heating caused by the current, the phase change material around the contacting surface 20 changes from a crystalline state to an amorphous state. A current required to change the phase change material from the crystalline state depends on the size of the contacting surface 20. That is, the smaller the contacting surface 20 is, the less current that is required to change the phase change material from the crystalline state. However, the configuration of a conventional phase change memory device having a thin film type phase change material is limited when the size of the contacting surface 20 is reduced.

US2004/0052117 describes a phase change memory device in which ultra-small resistive elements are formed in nano-size openings.

### SUMMARY OF THE INVENTION

According to the present invention, there is provided a method of making a phase change memory device including a first electrode and a second electrode facing each other, a phase change material layer containing phase change nano particles interposed between the first electrode and the second electrode, and a switching device electrically connected to the first electrode, according to claim 1.

Example embodiments of the present invention provide methods of fabricating a phase change memory device consuming less power and/or having improved current-voltage characteristics.

### BRIEF DESCRIPTION OF THE DRAWINGS

The present invention will become more apparent by describing in detail example embodiments thereof with reference to the attached drawings in which:
FIG. 1 is a graph illustrating a conventional method of operating a phase change memory device;
FIG. 2 is a cross sectional view of a phase change memory device according to the conventional art;
FIG. 3 is a cross sectional view of a phase change memory device manufactured according to an example embodiment of the present invention;
FIG. 4 is a graph illustrating estimated reset currents of a phase change memory device according to an example embodiment of the present invention and a conventional phase change memory device;
FIGS. 5A through 5E are SEM pictures of phase change nano particles which are thermally processed at 100, 200, 300, 400, and 500°C respectively;
FIG. 6A is a SEM image of Ge₂Sb₂Te₅ nano particles used for EDX analysis;
FIG. 6B is a graph showing a result of the EDX analysis of the nano particles;
FIG. 7 is a graph of chemical composition ratio of Ge₂Sb₂Te₅ nano particles according to the temperature of a thermal process;
FIGS. 8A through 8C views showing a method of fabricating a phase change memory device according to an example embodiment of the present invention;
FIG. 9 is a cross sectional view of a phase change memory device fabricated according to an example embodiment for observing a current-voltage (I-V) characteristics;
FIG. 10 is a graph illustrating voltage and current pulses used for resetting the phase change memory device shown in FIG. 9; and
FIG. 11 is a graph of the current-voltage (I-V) characteristics of the phase change memory device shown in FIG. 9.

### DETAILED DESCRIPTION OF EXAMPLE EMBODIMENTS OF THE INVENTION

Various example embodiments of the present invention will now be described more fully with reference to the accompanying drawings in which some example embodiments of the invention are shown. In the drawings, the thicknesses of layers and regions are exaggerated for clarity.

Detailed illustrative embodiments of the present invention are disclosed herein. However, specific structural and functional details disclosed herein are merely representative for purposes of describing example embodiments of the present invention. This invention may, however, may be embodied in many alternate forms and should not be construed as limited to only the embodiments set forth herein.

Accordingly, while example embodiments of the invention are capable of various modifications and alternative forms, embodiments thereof are shown by way of example in the drawings and will herein be described in detail. It should be understood, however, that there is no intent to limit example embodiments of the invention to the particular forms disclosed, but on the contrary, example embodiments of the invention are to cover all modifications, equivalents, and alternatives falling within the scope of the invention. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments of the present invention. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between", "adjacent" versus "directly adjacent", etc.).

The terminology used herein is for the purpose of describing particular embodiments only and is not intended to be limiting of example embodiments of the invention. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

It should also be noted that in some alternative implementations, the functions/acts noted may occur out of the order noted in the FIGS. For example, two FIGS. shown in succession may in fact be executed substantially concurrently or may sometimes be executed in the reverse order, depending upon the functionality/acts involved.

A phase change memory device manufactured according to an embodiment of the present invention may include a first electrode and a second electrode facing each other, a phase change material layer containing phase change nano particles interposed between the first electrode and the second electrode, and a switching device electrically connected to the first electrode. In an example embodiment, the switching device may be a transistor or diode.

In an example embodiment, the phase change material may include a chalcogenide.

For example, the phase change material may include chalcogenide alloys such as germanium-antimony-tellurium (Ge-Sb-Te), arsenic-antimony-tellurium (As-Sb-Te), tin-antimony-tellurium (Sn-Sb-Te), or tin-indium-antimony-tellurium (Sn-In-Sb-Te), arsenic-germanium-antimony-tellurium (As-Ge-Sb-Te). Alternatively, the phase change material may include an element in Group VA-antimony-tellurium such as tantalum-antimony-tellurium (Ta-Sb-Te), niobium-antimony-tellurium (Nb-Sb-Te) or vanadium-antimony-tellurium (V-Sb-Te) or an element in Group VA-antimony-selenium such as tantalum-antimony-selenium (Ta-Sb-Se), niobium-antimony-selenium (Nb-Sb-Se) or vanadium-antimony-selenium (V-Sb-Se). Further, the phase change material may include an element in Group VIA-antimony-tellurium such as tungsten-antimony-tellurium (W-Sb-Te), molybdenum-antimony-tellurium (Mo-Sb-Te), or chrome-antimony-tellurium (Cr-Sb-Te) or an element in Group VIA-antimony-selenium such as tungsten-antimony-selenium (W-Sb-Se), molybdenum-antimony-selenium (Mo-Sb-Se) or chrome-antimony-selenium (Cr-Sb-Se).

Although the phase change material is described above as being formed primarily of ternary phase-change chalcogenide alloys, the chalcogenide alloy of the phase change material could be selected from a binary phase-change chalcogenide alloy or a quaternary phase-change chalcogenide alloy. Example binary phase-change chalcogenide alloys may include one or more of Ga-Sb, In-Sb, In-Se, Sb₂-Te₃ or Ge-Te alloys; example quaternary phase-change chalcogenide alloys may include one or more of an Ag-In-Sb-Te, (Ge-Sn)-Sb-Te, Ge-Sb-(Se-Te) or Te₈₁-Ge₁₅-Sb₂-S₂ alloy, for example.

In an example embodiment, the phase change material may be made of a transition metal oxide having multiple resistance states, as described above. For example, the phase change material may be made of at least one material selected from the group consisting of NiO, TiO₂, HfO, Nb₂O₅, ZnO, WO₃, and CoO or GST (Ge₂Sb₂Te₅) or PCMO(PrₓCa₁₋ₓMnO₃).

The phase change material may be a chemical compound including one or more elements selected from the group consisting of S, Se, Te, As, Sb, Ge, Sn, In and Ag, and a diameter of the nano particles may be in a range of 1 to 100 nm. There may be pores between the nano particles filled with a material, for example, an insulating material, for example, SiO₂ or Si₃N₄.

A phase change memory device manufacturing method according to an example embodiment of the present invention includes preparing a switching device, preparing a first electrode electrically connected to the switching device, forming a phase change material layer including phase change nano particles on the first electrode, and forming a second electrode on the phase change material layer.

The phase change nano particles may be derived from compound including at least one selected from the group consisting of S, Se, Te, As, Sb, Ge, Sn, In, and Ag. A diameter of the nano particles may be in a range from 1 to 100 nm.

The operation of forming the phase material layer includes preparing phase change nano particles and forming the phase change material layer including the phase change nano particles on the first electrode.

The phase change nano particles may be manufactured using one of the methods selected from the group consisting of laser ablation, sputtering, chemical vapor deposition, precipitation, electro spray, and/or a solution-based method. The phase change nano particles may be manufactured using laser ablation.

After preparing the phase change nano particles, a thermal process may be additionally performed to more uniformly form phase change nano particles. The thermal process may be performed at 100 to 650°C. In an example embodiment, the thermal process may be performed at 200 to 300°C.

The prepared phase change nano particles may be deposited on the first electrode using a thermophoresis method or an electrophoresis method and the phase change nano particles may be deposited as one or more layers.

A desired material, for example an insulating material, may be supplied to fill pores between the phase change nano particles when forming the phase material layer with the phase change nano particles on the first electrode. The insulating material may be SiO₂ or Si₃N₄.

The phase change nano particles may be doped with nitrogen or silicon to adjust the physical property of the phase change nano particles of the phase change material layer.

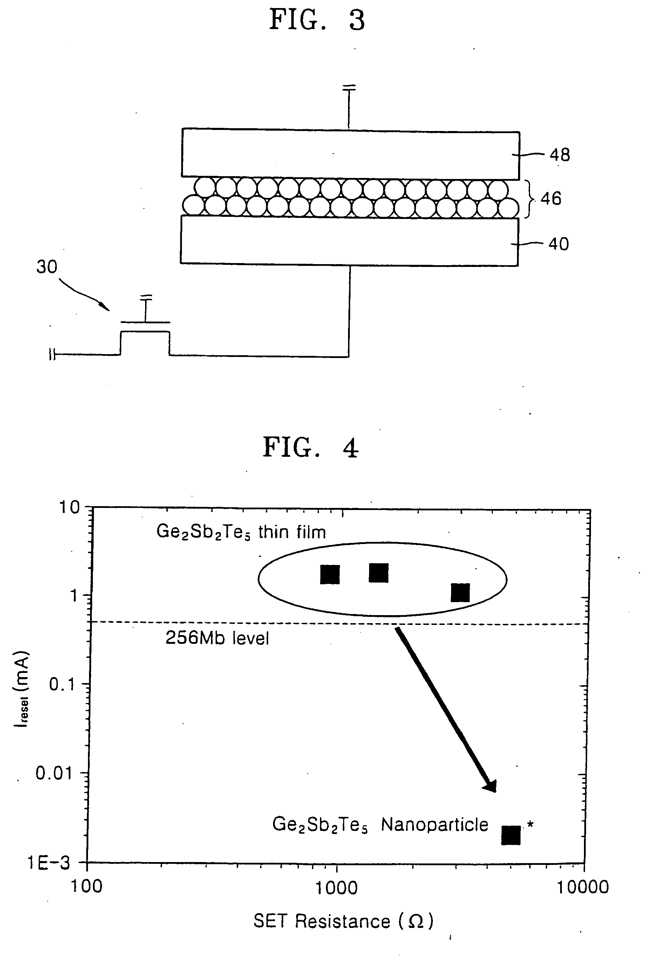

FIG. 3 is a cross-sectional view of phase change memory device manufactured according to an example embodiment of the present invention.

Referring to FIG. 3, the phase change memory device includes a first electrode 40 wand a second electrode 48 facing each other, a phase change material layer 46 interposed between the first electrode 40 and the second electrode 48, and/or a transistor 30 electrically connected to the first electrode 40. The first electrode 40 and the second electrode 48 may be formed of a conductive material. The phase change memory device may further include a resistive heater having a small contact size on the first electrode 40. The configuration of the first and second electrodes 40 and 48 is well known to those of ordinary skill in the art. Therefore, a detailed explanation thereof is omitted.

If a current flows into the phase change memory device through the transistor 30 or the first electrode 40, the current flows from the first electrode 40 to the second electrode 48 and the state of the phase change material layer 46 interposed between the first electrode 40 and the second electrode 48 is changed according to the amplitude of the current as a result of Joule heating. That is, according to amplitude of the current supplied to the phase change material 46 and the period when the current flows, the phase change material layer 46 may be changed to an amorphous state or a crystalline state, and the phase change material layer 46 may have different electric conductivities according to whether it is in the amorphous state or the crystalline state. The resistivity of the phase change material layer 46 in the amorous state is higher than the resistivity of the phase change material layer 46 in the crystalline state. Accordingly, data stored in the phase change memory device can be discriminated as logic 1 or logic 0 by detecting a current flowing through the phase change material 46 in a read mode.

In an example embodiment, the phase change material layer 46 contains phase change nano particles. Because the phase change material layer 46 contains phase change nano particles, a current Ireset for changing the phase change material layer 46 from a crystalline state to an amorphous state may be less than the current required in the conventional thin film type of a phase change material, as shown in FIG. 4.

FIG. 4 is a graph showing an estimated value of reset currents of a phase change memory device manufactured according to an example embodiment of the present invention and a conventional phase change memory device having a thin film type phase change material layer. Each of the phase change memory devices includes a phase change material layer having a width of 0.5µm and a thickness of 0.1 µm, a bottom electrode having a width of 50nm and a top electrode having a width of 0.5µm. Referring to FIG. 4, the reset current (Ireset) required to change the state of the phase change material layer containing phase change nano particles in the phase change memory device according to an example embodiment of the present invention is smaller than reset currents of the conventional memory device having a thin film type of phase change material layer. The conventional memory device having a thin film type of phase change material layer generally requires a reset current in the range of 0.5 to 2mA.

Accordingly, a phase change memory device manufactured according to example embodiments of the present embodiment may be operated with a lower operating current and/or consume less electric power compared to the conventional phase change memory device having a thin film type phase change material layer. It is also possible to use a small sized switching device with a phase change memory device according to example embodiments of the present embodiment because the operating current is reduced by forming the phase change material layer with phase change nano particles. Therefore, the size of the phase change memory device may be reduced and/or the integrity of the phase change memory device may be increased. Furthermore, characteristics of the phase change material layer 46 may be easily controlled because it is easier to control the formation and size of the nano particles. Therefore, the phase change material layer 46 may be modified to have new characteristics through surface processing of the phase change nano particles.

Hereinafter, a method of fabricating a phase change memory device according to an example embodiment of the present invention will be described with reference to accompanying drawings.

### Example 1: Manufacturing of phase change nano particles

Phase change nano particles of the phase change material layer 46 are manufactured using a laser ablation method under the following conditions. An ArF excimer laser having a wavelength of 193nm is used. The frequency of a laser pulse is 5Hz and the width of the pulse is 30 nanoseconds. A Ge₂Sb₂Te₅ material is used as a target of laser ablation. The laser ablation is performed under an argon gas atmosphere at 13.3 to 667 Pa (0.1 to 5 Torr) and a laser energy density of 2 to 5 J per cm2 is used for manufacturing the phase change nano particles having an average size of 10 to 30 nm.

Phase change nano particles of the phase change material layer 46 may be manufactured using other methods for example CVD, PVD or a chemical route.

### Example 2: Physical property variation of the phase change particles according to a thermal process

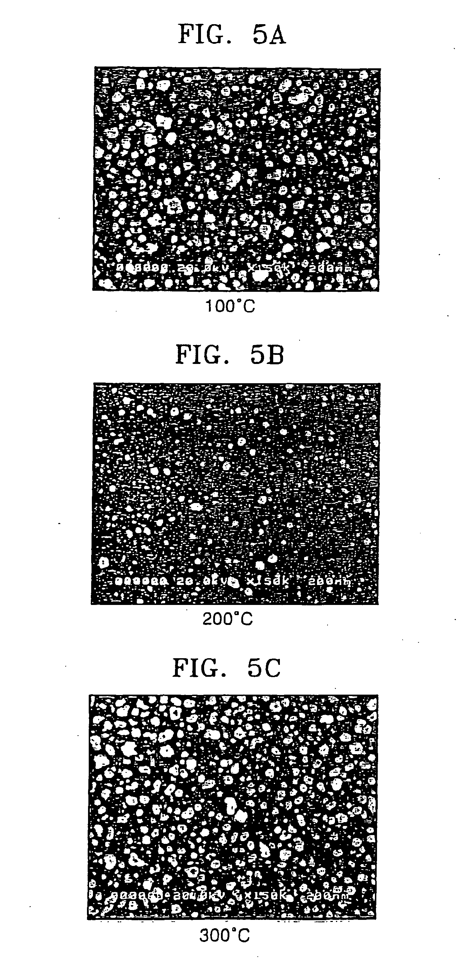

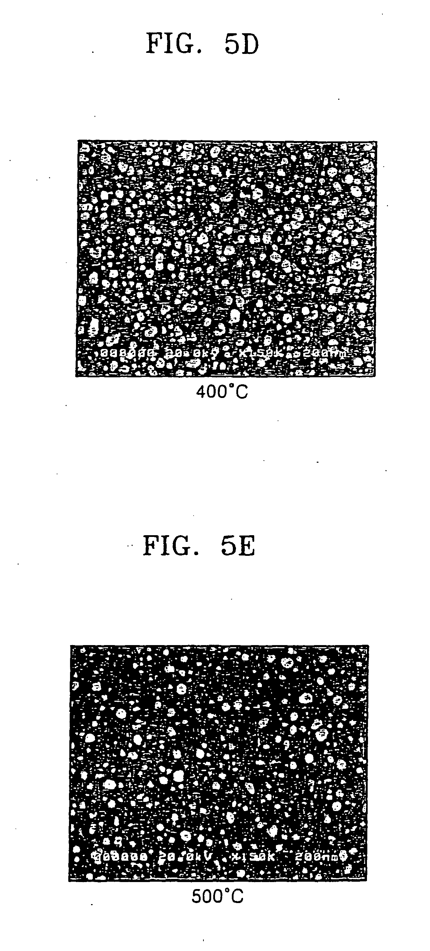

The phase change particles may be thermal processed in a temperature range of 100 to 650°C, examples of thermal processed phase change materials are shown in FIGS. 5A through 5E.

A physical property or a chemical property of the phase change nano particles may be varied according to the temperature of the thermal process and the varied property of the phase change nano particles may influence a property of the phase change material layer 46.

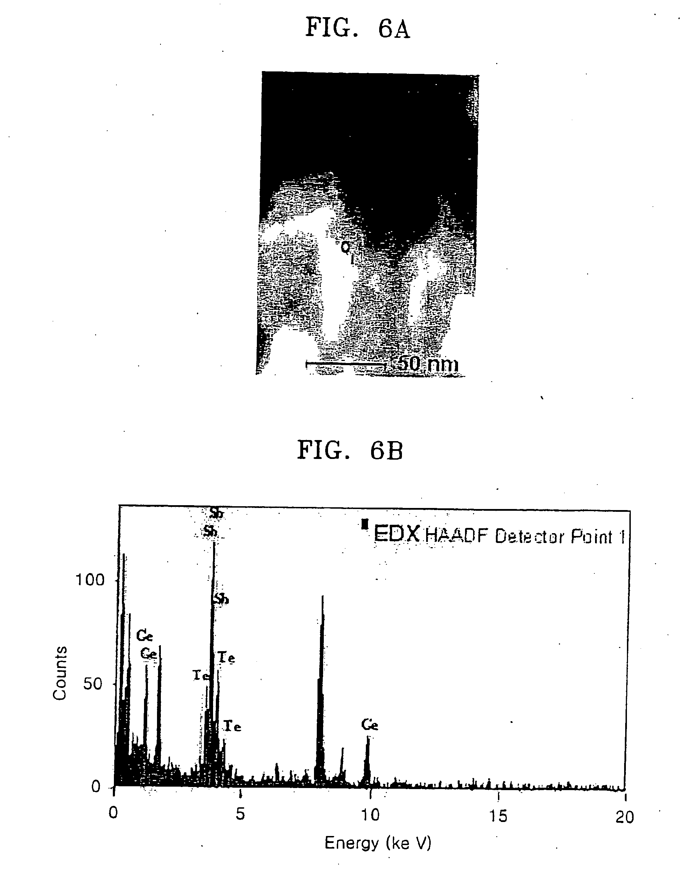

FIG. 6A is a scanning electron microscope (SEM) image of Ge₂Sb₂Te₅ nano particles used for energy dispersive x-ray (EDX) analysis and FIG. 6B is a graph showing a result of EDX analysis of Ge₂Sb₂Te₅ nano particles. In the SEM image of FIG. 6A, an area 1 denotes an EDX analysis area.

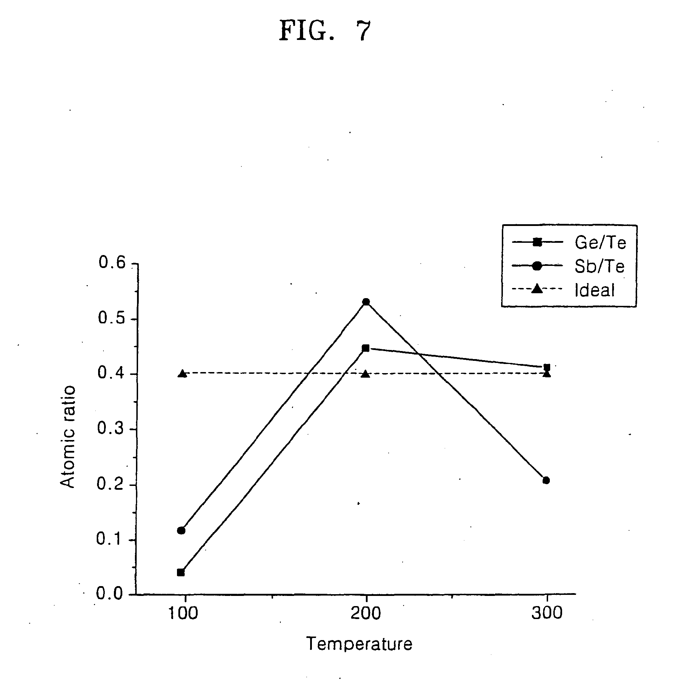

FIG. 7 is a graph of the chemical compound ratio of Ge₂Sb₂Te₅ nano particles according to the temperature of a thermal process.

Referring to FIG. 7, the Ge₂Sb₂Te₅ nano particles are thermally processed at temperatures of 100, 200, and 300°C. In the graph, a dependence of chemical composition on the temperature of the thermal process is observed. For example, the chemical compound of the nano particles becomes stoichiometric when the nano particles is thermally processed at temperatures higher than 100°C. In particular, the nano particles are most stoichiometric when the nano particles are thermally processed at 200°C. Accordingly, the most stoichiometric and crystalline Ge₂Sb₂Te₅ nano particles can be obtained by performing the thermal process at 200°C.

### Example 3: Fabrication of phase change memory device according to an example embodiment of the present invention:

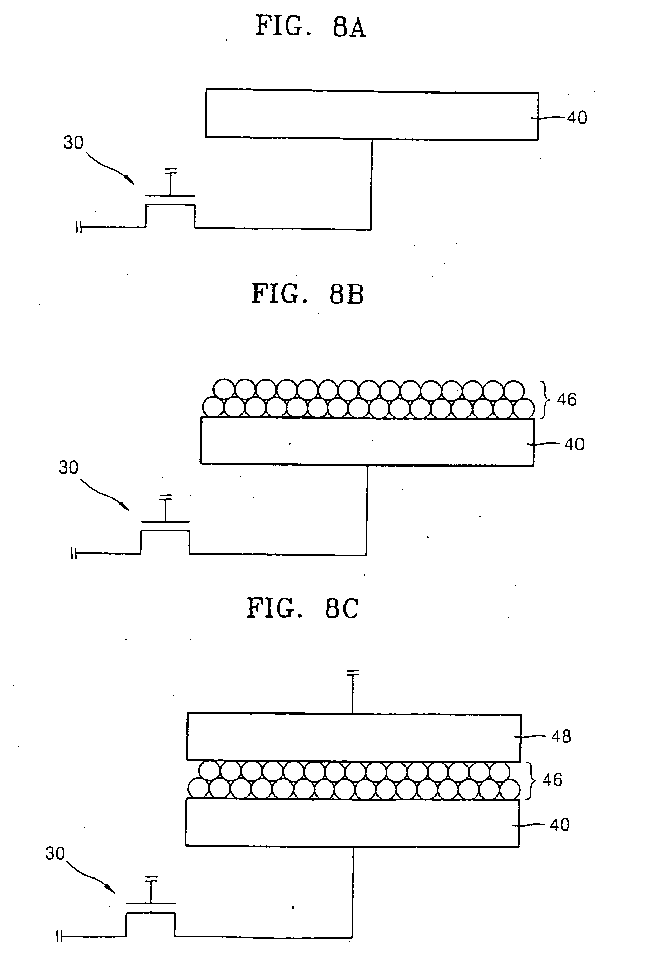

FIGS. 8A through 8C are cross-sectional views illustrating a method of fabricating a phase change memory device according to an example embodiment of the present invention. Like reference in FIGS. 8A through 8C numerals denote like elements.

Referring to FIG. 8A, a transistor 30 is electrically connected to a first electrode 40. A resistive heater having a small contact size may be further included on the first electrode 40. The configuration of the first electrode 40 in the phase change memory device is well known to those skilled in the art. Accordingly, a detailed explanation thereof is omitted. Referring to FIG. 8B, phase change nano particles may be prepared as described above. After preparing the phase change nano particles, a phase change material layer 46 is formed by depositing the phase change nano particles on the first electrode using a thermophoresis method. That is, a 200°C temperature difference may be maintained between the substrate and a thermophoresis apparatus to deposit the phase change nano particles on the first electrode 40. Referring to FIG. 8C, a second electrode 48 is formed on the phase change material layer 46. The first electrode 40 and the second electrode 48 may be composed of the conductive material. According to the above-described processes, the phase change memory device according to an example embodiment is manufactured.

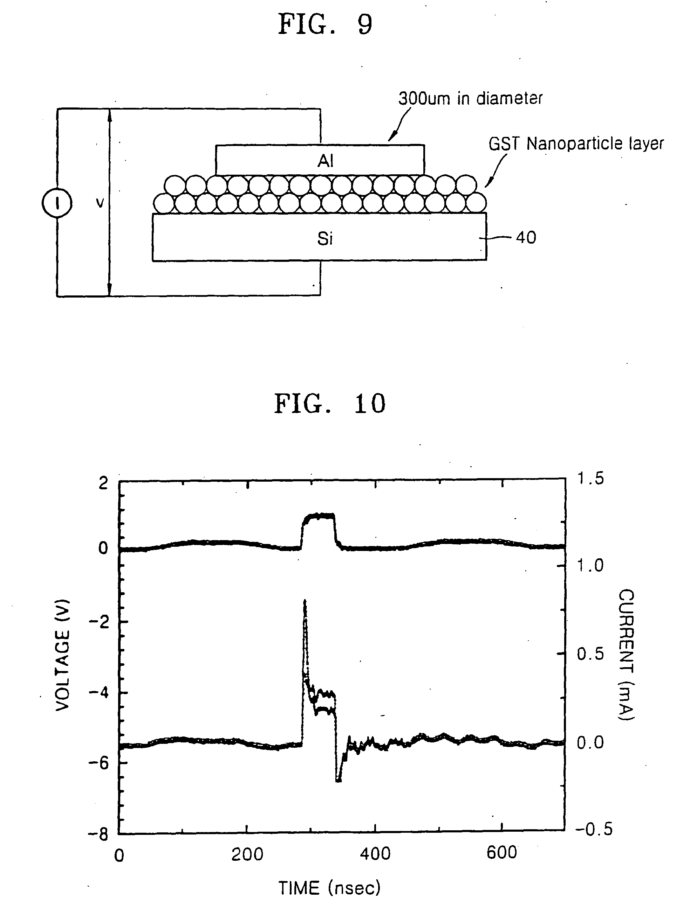

FIG. 9 is a schematic cross sectional view of a phase change memory device fabricated according to an example embodiment of the present invention for observing current-voltage (I-V) characteristics.

First, phase change nano particles having an average size of 10nm were fabricated according to the laser ablation method described above using a laser energy density of 2.5 J/cm2 under a pressure of 267 Pa (2 Torr). The fabricated phase change nano particles were thermally processed at 200°C. A phase change memory device was then formed according to an example embodiment of the present invention as described above. That is, Ge₂Sb₂Te₅ nano particles were deposited on a Si substrate to have a thickness of 50 nm and an Al electrode having a diameter of 300µm was formed on the nano particles. The I-V characteristics according to a phase change were observed while a current flowed between the Al electrode and the Si substrate.

FIG. 10 is a graph showing voltage and current pulses used for resetting the phase change memory device shown in FIG. 9. The term "reset" means a state transition of a phase change material from a crystalline state (low resistance) to an amorphous state (high resistance). FIG. 10 shows the current observed when 1 V is applied for 50 ns. Referring to FIG. 10, the average amplitude of the current was 0.3 mA and maximum amplitude of the current was 0.8 mA. Therefore, a wider area of the electrode can be reset using a lower current in the phase change memory device according to an example embodiment compared to the conventional art. FIG. 4 shows the expected reset current calculated from the data shown in FIG. 10. 0.5 to 1.5 mA is generally required for resetting a 64M PRAM having conventional bottom electrode with a diameter of 50 nm.

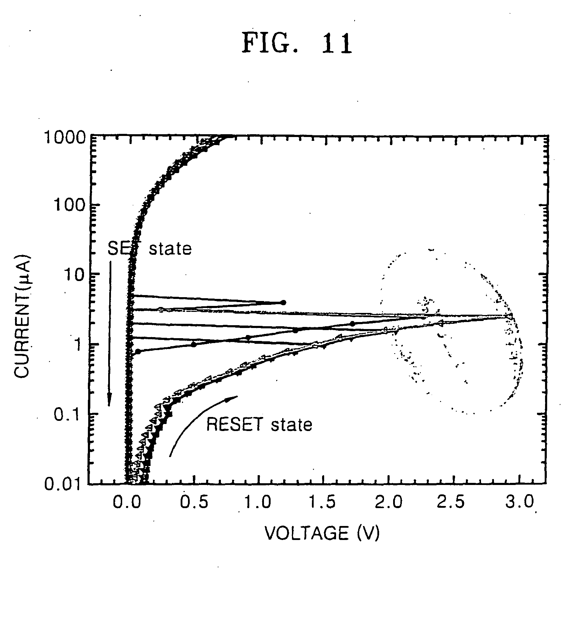

FIG. 11 is a graph of the current-voltage (I-V) characteristics of the phase change memory device shown in FIG. 9. If the phase change memory device shown in FIG. 9 is reset by supplying the pulses shown in FIG. 10, the phase change material layer enters high resistance state. This is illustrated as a RESET state in the graph of FIG. 11. If the current flowing through the phase change memory layer is gradually increased in the high resistance state, the temperature of the phase change memory layer increases, and thus the state of the phase change material layer is changed from an amorphous state to a crystalline state. If the current flowing the phase change memory layer is reduced in the SET state, the phase change material layer enters a low resistance state. This is illustrated as SET state in the graph of FIG. 11. If a reset pulse is supplied after reducing the current to 0, the state of the phase change material layer is changed from the crystalline state to the amorphous state. While repeatedly changing the state of the phase change memory device, the I-V characteristics were observed. The graph shows that RESET-SETs are repeatedly and stably performed.

According to example embodiments of the present invention, a method of fabricating a phase change memory device having a phase change material layer containing phase change nano particles between two electrodes is provided. A reset current Ireset required for the phase change material layer; to change its state from a crystalline state to an amorphous state is lower than that for a thin film phase change material layer of a conventional phase change memory device. Thus, operating current and/or power consumption of the phase change memory device fabricated according to example embodiments the present invention may be greatly reduced compared with the conventional phase change memory device.

Further, it may be easier to control the size and/or formation of phase change nano particles, the characteristics of the phase change material can also be easily controlled and different characteristics of a phase change material layer can be obtained by surface treatment of the phase change nano particles.

By using phase change nano particles to form the phase material layer of the phase change memory, the phase change memory can be operated with a comparatively less operating current, and thus it is possible to use a smaller sized switching device. Therefore, higher integrity and/or improved reproducibility of the phase change memory device may be obtained.

The phase change memory device fabricated according to example embodiments of the present invention and the method of fabricating the same may be implemented to manufacture a next generation semiconductor memory deice.

While the present invention has been particularly shown and described with reference to example embodiments thereof, it will be understood by those of ordinary skill in the art that various changes in form and details may be made therein without departing from the scope of the present invention as defined by the following claims.

## Claims

1. A method of fabricating a phase change memory device, the method comprising:
preparing a switching device (30);
preparing a first electrode (40) electrically connected to the switching device;
forming a phase change material layer (46) including phase change nano particles on the first electrode; and
forming a second electrode (48) on the phase change material layer;
**characterised in that** forming the phase change material layer (46) includes:
preparing the phase change nano particles; and
forming the phase change material layer including the phase change nano particles on the first electrode.

2. The method of claim 1, wherein the phase change material is a compound including at least one selected from the group consisting of S, Se, Te, As, Sb, Ge, Sn, In, and Ag.

3. The method of claim 1 or 2, wherein a diameter of the nano particles is in a range from 1 to 100nm.

4. The method of claim 1, 2 or 3, wherein the phase change nano particles are formed by at least one of laser ablation, sputtering, chemical vapor deposition, precipitation, electro spraying and a solution-based method.

5. The method of claim 4, wherein the phase change nano particles are formed by laser ablation.

6. The method of claim 1 to 5 further comprising performing a thermal process after the preparing the phase change nano particles.

7. The method of claim 6, wherein the thermal process is performed at a temperature of 100 to 650°C.

8. The method of any one of claims 1 to 7, wherein forming the phase change material layer further includes supplying a material to fill pores between the phase change nano particles.

9. The method of claim 8, wherein the material is an insulation material.

10. The method of claim 9, wherein the insulating material is at least one of SiO₂ or Si₃N₄.

11. The method of any one of claims 1 to 10, further comprising doping the phase change nano particles of the phase change material layer with particles after the preparing the phase change nano particles.

12. The method of claim 11, wherein the particles are at least one of nitride and silicon.

## Patentansprüche

1. Verfahren zur Herstellung einer Phasenwechselspeichervorrichtung, wobei das Verfahren umfasst:
Vorbereiten einer Schaltvorrichtung (30),
Vorbereiten einer ersten Elektrode (40), die mit der Schaltvorrichtung elektrisch verbunden ist,
Bilden einer Phasenwechselmaterialschicht (46), die Phasenwechsel-Nanopartikel umfasst, auf der ersten Elektrode und
Bilden einer zweiten Elektrode (48) auf der Phasenwechselmaterialschicht,
**dadurch gekennzeichnet, dass** das Bilden der Phasenwechselmaterialschicht (46) umfasst:
Vorbereiten der Phasenwechsel-Nanopartikel und
Bilden der Phasenwechselmaterialschicht, die die Phasenwechsel-Nanopartikel umfasst, auf der ersten Elektrode.

2. Verfahren nach Anspruch 1, wobei das Phasenwechselmaterial eine Verbindung ist, die mindestens eine Komponente ausgewählt aus der Gruppe bestehend aus S, Se, Te, As, Sb, Ge, Sn, In und Ag umfasst.

3. Verfahren nach Anspruch 1 oder 2, wobei ein Durchmesser der Nanopartikel im Bereich von 1 bis 100 nm liegt.

4. Verfahren nach Anspruch 1, 2 oder 3, wobei die Phasenwechsel-Nanopartikel durch Laserablation, Sputtern, chemische Gasphasenabscheidung, Ausfällen, Elektrospritzen und/oder einem lösungsbasierten Verfahren gebildet werden.

5. Verfahren nach Anspruch 4, wobei die Phasenwechsel-Nanopartikel durch Laserablation gebildet werden.

6. Verfahren nach Anspruch 1 bis 5, weiter umfassend Durchführen eines thermischen Prozesses nach dem Vorbereiten der Phasenwechsel-Nanopartikel.

7. Verfahren nach Anspruch 6, wobei der thermische Prozess bei einer Temperatur von 100 bis 650 °C durchgeführt wird.

8. Verfahren nach einem der Ansprüche 1 bis 7, wobei Bilden der Phasenwechselmaterialschicht weiter Zuführen eines Materials zum Füllen von Poren zwischen den Phasenwechsel-Nanopartikeln umfasst.

9. Verfahren nach Anspruch 8, wobei das Material ein Isoliermaterial ist.

10. Verfahren nach Anspruch 9, wobei das Isoliermaterial SiO₂ und/oder Si₃N₄ ist.

11. Verfahren nach einem der Ansprüche 1 bis 10, weiter umfassend Dotieren der Phasenwechsel-Nanopartikel der Phasenwechselmaterialschicht mit Partikeln nach dem Vorbereiten der Phasenwechsel-Nanopartikel.

12. Verfahren nach Anspruch 11, wobei die Partikel Nitrid und/oder Silicium sind.

## Revendications

1. Procédé de fabrication d'une mémoire à changement de phase, ledit procédé comprenant :
la préparation d'un dispositif de commutation (30)
la préparation d'une première électrode (40) connectée électriquement au dispositif de commutation;
la formation d'une couche de matériau à changement de phase (46) comprenant des nanoparticules à changement de phase sur la première électrode ; et
la formation d'une deuxième électrode (48) sur la couche de matériau à changement de phase ;
**caractérisé en ce que** la formation de la couche de matériau à changement de phase (46) comprend :
la préparation des nanoparticules à changement de phase ; et
la formation de la couche de matériau à changement de phase comprenant les nanoparticules à changement de phase sur la première électrode.

2. Procédé selon la revendication 1, dans lequel le matériau à changement de phase est un composé comprenant au moins un élément sélectionné dans le groupe constitué de S, Se, Te, As, Sb, Ge, Sn, In, et Ag.

3. Procédé selon la revendication 1 ou 2, dans lequel le diamètre des nanoparticules est dans la plage de 1 à 100 nm.

4. Procédé selon la revendication 1, 2 ou 3, dans lequel les nanoparticules à changement de phase sont formées par au moins l'un des procédés suivants :
ablation au laser, pulvérisation cathodique, dépôt chimique en phase vapeur, précipitation,
électronébulisation et un procédé à base de solution.

5. Procédé selon la revendication 4, dans lequel les nanoparticules à changement de phase sont formées par ablation au laser.

6. Procédé selon les revendications 1 à 5, comprenant en outre l'exécution d'un procédé thermique après la préparation des nanoparticules à changement de phase.

7. Procédé selon la revendication 6, dans lequel le procédé thermique est exécuté à une température de 100 à 650°C.

8. Procédé selon l'une quelconque des revendications 1 à 7, dans lequel la formation de la couche de matériau à changement de phase comprend en outre la fourniture d'un matériau pour remplir les pores entre les nanoparticules à changement de phase.

9. Procédé selon la revendication 8, dans lequel le matériau est un matériau d'isolation.

10. Procédé selon la revendication 9, dans lequel le matériau isolant est le SiO₂ et/ou le Si₃N₄.

11. Procédé selon l'une quelconque des revendications 1 à 10, comprenant en outre le dopage des nanoparticules à changement de phase de la couche de matériau à changement de phase avec des particules après la préparation des nanoparticules à changement de phase.

12. Procédé selon la revendication 11, dans lequel les particules sont un nitrure et/ou le silicium.
